(19) **Europäisches Patentamt**

**European Patent Office**

**Office européen des brevets**

(11) **EP 1 148 640 B1**

(12) **EUROPEAN PATENT SPECIFICATION**

(45) Date of publication and mention
of the grant of the patent:
**22.02.2006 Bulletin 2006/08**

(51) Int Cl.:
***H03H 17/04*** (2006.01)

(21) Application number: **01108195.7**

(22) Date of filing: **30.03.2001**

(54) **Digital filter and reference signal cancelling device using the same**

Digitales Fiter und dieses enthaltende Vorrichtung zur Unterdrückung von Referenzsignalen

Filtre numérique et dispositif de suppression de signal de référence le comprenant

(84) Designated Contracting States:
**DE FR GB**

(30) Priority: **31.03.2000 JP 2000099766**

(43) Date of publication of application:
**24.10.2001 Bulletin 2001/43**

(73) Proprietor: **Pioneer Corporation**
**Tokyo 153-8654 (JP)**

(72) Inventor: **Yamamoto, Yuji,**
**Pioneer Corporation**
**Yamada,**
**Kawagoe-shi,**
**Saitama 350-8555 (JP)**

(74) Representative: **Grünecker, Kinkeldey,**
**Stockmair & Schwanhäusser**
**Anwaltssozietät**
**Maximilianstrasse 58**
**80538 München (DE)**

(56) References cited:
- **RICHARD G. LYONS: "Understanding Digital Signal Processing" 1997 , ADDISON WESLEY , U.S.A. XP002270306 * page 242 - page 254 * * page 279 ***
- **MICHAEL A. SODERSTRAND: "Design of High-Speed Digital Bandpass Filters without Multipliers" IEEE PROCEEDINGS OF THE INTERNATIONAL SYMPOSIUM ON CIRCUITS AND SYSTEMS, vol. 4, no. 25, 3 May 1992 (1992-05-03), pages 553-556, XP010061275 New York, U.S.A.**
- **HENRY SAMUELI: "A Low-Complexity Multiplierless Half-Band Recursive Digital Filter Design" IEEE TRANSACTIONS ON ACOUSTICS, SPEECH AND SIGNAL PROCESSING, vol. 37, no. 3, 1 March 1989 (1989-03-01), pages 442-444, XP000121358 New York, US**

**Description**

1. Field of the Invention

This invention relates to a second-order IIR type digital filter and a reference signal canceling device using it.

2. Description of the Related Art

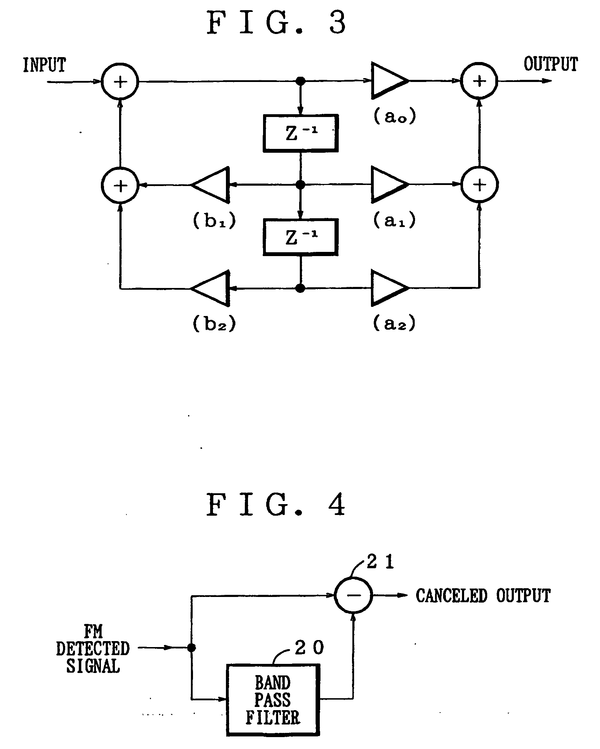

In FM stereo broadcasting, an FM detected signal includes a pilot signal at a single frequency of 19 KHz which is a reference for stereo demodulation. In order to cancel such a pilot signal, the circuit as shown in Fig. 4 has been proposed. Specifically, the pilot signal is extracted by a bandpass filter 20 which is an IIR (Infinite Impulse Response) filter and supplied to an attenuator 21, thereby canceling the pilot signal.
However, the above IIR filter provides changes in a central frequency and phase characteristic according to the accuracy in the coefficient of the filter. In order to remove the change, the number of bits of the coefficient must be increased. This gave raise to an increase in the circuit size and production cost.
An object of this invention is to provide a second-order IIR type digital filter with a simple arrangement and high accuracy.
Lyons, R.G. "Understanding Digital Signal Processing" 1997, Addison Wesley, USA., page 252-279, is an excerpt from a textbook on filter design. This particular chapter concentrates on IIR filters. A final simplified direct form II filter structure with feedback is shown.
Soderstrand, M.A.: "Design of High-Speed Digital Bandpass Filters without Multipliers", IEEE Proceedings of the International Symposium on Circuits and Systems, vol. 4, no. 25, 3 May 1992, pages 553-556, is a scientific publication on the design of high-speed bandpass filters, in this case FIR bandpass filters with sampling frequencies six times the central frequency of a passing frequency band. In this case the design can be simplified by eliminating multipliers. An example of a basic bandpass filter is shown.
The object is solved by the invention as claimed in the independent claim. Preferred embodiments of the invention are defined by the dependent claims.
The above object and features of the invention will be more apparent from the following description taken in conjunction with the accompanying drawings.

    Fig. 1 is a block diagram showing the first embodiment of this invention;
    Fig. 2 is a block diagram showing the second embodiment of this invention;
    Fig. 3 is a block diagram showing a second-order IIR type digital filer; and
    Fig. 4 is a block diagram showing a conventional pilot signal canceling apparatus.

Prior to explaining an embodiment of this invention, referring to Fig. 3, an explanation will be given of the operating theory of this invention.
Fig. 3 shows the arrangement of a general second-order IIR type digital filter.
In Fig. 3, the transfer function H(Z) of the filter can be expressed by

$$H(Z) = (a_0 + a_1 Z^{-1} + a_2 Z^{-2})$$

$$/ (1 + b_1 Z^{-1} + b_2 Z^{-2}) \qquad \cdots \qquad (1)$$

The amplitude characteristic $M(\omega)$ can be expressed by

$$M(\omega) = (O/Q)^{0.5} \qquad \cdots \qquad (2)$$

The delay characteristic $\tau(\omega)$ can be expressed by

$$\tau(\omega) = (P/O - R/Q) T \qquad \cdots \qquad (3)$$

where

$$O_2 = A^2 + C^2$$

$$P = C(C + a_2 Sin2\omega T) - A(A - a_0 + a_2 Cos2\omega T)$$

$$Q = B^2 + D^2$$

$$R = D(D + b_2 Sin2\omega T) + B(B - 1 + b_2 Cos2\omega T)$$

$$T = \text{sampling time}$$

$$\cdots \qquad (4)$$

where

$$A = a_0 + a_1 Cos\omega T + a_2 Cos2\omega T$$

$$B = 1 + b_1 Cos\omega T + b_2 Cos2\omega T$$

$$C = a_1 Sin\omega T + a_2 Sin2\omega T$$

$$D = b_1 Sin\omega T + b_2 Sin2\omega T$$

$$\cdots \qquad (5)$$

In the general form of the second bandpass filter,

$$a_1 = 0$$

$$a_2 = b_2 - a_0$$

$$\cdots \qquad (6)$$

Setting the sampling frequency fs (= 1/T) at six times as large as the central frequency of the bandpass filter,

$$\omega c \ T = 2\pi fc \ T = \pi/3 \qquad \cdots \qquad (7)$$

$$2\omega c \ T = 2\pi/3 \qquad \cdots \qquad (8)$$

Further

$$Cos \ 2\omega T = -Cos\omega T \qquad \cdots \qquad (9)$$

$$Sin\ 2\omega T = Sin\omega T \qquad \cdots \qquad (10)$$

$$2Cos\omega T = 1 \qquad \cdots \qquad (11)$$

Assuming that

$$a_0 = a,\ a_2 = -a \qquad \cdots \qquad (12)$$

in Equation (5),

$$A = a + aCos\ \omega T$$
$$B = (2 + b_1 - b_2)Cos\omega T$$
$$C = -aSin\omega T$$
$$D = (b_1 + b_2)Sin\omega T$$

$$\cdots \qquad (13)$$

Therefore, in Equation (4),

$$O = 2a^2(1 + Cos\omega T)$$
$$Q = (2 + b_1 - b_2)^2Cos^2\omega T + (b_1 + b_2)^2Sin\omega T$$
$$P = 2a^2(Sin^2\omega T - Cos^2\omega T - Cos\omega T)$$
$$R = (b_1 + b_2)\ (b_1 + 2b_2)Sin^2\omega T$$
$$\qquad + (2 + b_1 - b_2)\ (b_1 - 2b_2)Cos^2\omega T$$

$$\cdots \qquad (14)$$

Assuming that

$$b_1 = -(1-a)$$
$$b_2 = 1 - 2a$$

$$\cdots \qquad (15)$$

4

$$b_1 + b_2 = -a$$

$$b_1 + 2b_2 = 1 - 3a$$

$$2 + b_1 - b_2 = 3a$$

$$b_1 - 2b_2 = -3 + 5a$$

$$\cdots \quad (16)$$

Substituting Equation (16) into Q and R in Equation (14),

$$Q = 9a^2 \cos\omega T + a^2 \sin^2\omega T$$

$$R = -a(1 - 3a)\sin^2\omega T + 3a(-3 + 5a)\cos^2\omega T$$

$$\cdots \quad (17)$$

Considering Equation (7),

$$\cos^2\omega T = 1/4, \quad \sin^2\omega T = 3/4 \qquad \cdots \quad (18)$$

Therefore,

$$O = 3a^2$$

$$p = 0$$

$$Q = 3a^2$$

$$R = 3a(2a - 1)$$

$$\cdots \quad (19)$$

Thus, substituting Equation (19) into Equation (3), the amplitude characteristic M($\omega$) is expressed by

$$M(\omega) = (O/Q)^{0.5} = 1 \qquad \cdots \quad (20)$$

The delay characteristic $\tau(\omega)$ is expressed by

$$\tau(\omega) = (P/O - R/Q)\,T$$

$$= (1 - 2a)/6af_c \qquad \cdots \quad (21)$$

Now, assuming that

$$a = 2^{-n} \quad (n: \text{ integer of } 0 \text{ or more}) \qquad \dots \quad (22)$$

the delay characteristic $\tau(\omega)$ is expressed by

$$\tau(\omega) = (2^n - 2)/6f_c \qquad \dots \quad (23)$$

Assuming that

$$n = 3, 5, 7, 9, \dots \dots \quad (n: \text{ positive integer other than } 1) \qquad \dots \quad (24)$$

$$\tau(\omega)f_c = 1, 5, 21, 85, \dots \qquad \dots \quad (25)$$

Namely, the group delay can be taken as integer times of $1/f_c$ and the phases of the central frequencies at the input and output agree with each other.

Assuming that

$$n = 2m + 1 \quad (m: \text{ integer of } 0 \text{ or more}) \qquad \dots \quad (26)$$

Equation (23) can be expressed by

$$\tau(\omega) = (2^{2m} - 1)/3f_c \qquad \dots \quad (27)$$

Using n in Equation (26), a in Equation (22) can be expressed by

$$a = 2^{-(2m+1)} \qquad \dots \quad (28)$$

Further, $b^1$ and $b^2$ in Equation (15) can be expressed by

$$b1 = -(1 - 2^{-(2m+1)})$$

$$b2 = 1 - 2^{-2m}$$

$$\dots \quad (29)$$

The procedure described above can be summarized as follows.

Assuming that

1. the sampling frequency fs is six-times of the central frequency of the bandpass filter,
2. n is an odd number of 3 or greater,
3. $a_0 = 2^{-n}$, $a_1 = 0$, $a_2 = -2^{-n}$

4. $b_1 = - (1 - 2^{-n})$ and

5. $b_2 = 1 - 2^{-(n-1)}$,

6. the amplitude characteristic $M(\omega c) = 1$ and

7. the delay characteristic $\tau(\omega c) = (2^n - 2)/6fc$.

Otherwise, assuming that

1'. the sampling frequency fs is six-times of the central frequency of the bandpass filter,

2'. m is an integer of m > 3,

3'. $a_0 = 2^{-(2m+1)}$, $a_1 = 0$, $a_2 = -2^{-(2m+1)}$

4'. $b_1 = - (1 - 2^{-(2m+1)})$ and

5. $b_2 = 1 - 2^{-2m}$,

6. the amplitude characteristic $M(\omega c) = 1$ and

7. the delay characteristic $\tau(\omega c) = (2^{2m} - 1)/3fc$.

(31)

Therefore, the phases and amplitudes at the central frequency at the input and output agree to each other.

Further, $a_0 = 2^{-(2m+1)}$, a multiplication by the coefficient can be calculated by "bit shift", thus facilitating the operation. In addition, because of no coefficient error, the operation can be carried with high accuracy.

The band of the filter becomes narrow as $a_0$ approaches 0. For this reason, the objective bandwidth can be acquired by selecting $a_0$ according to the object.

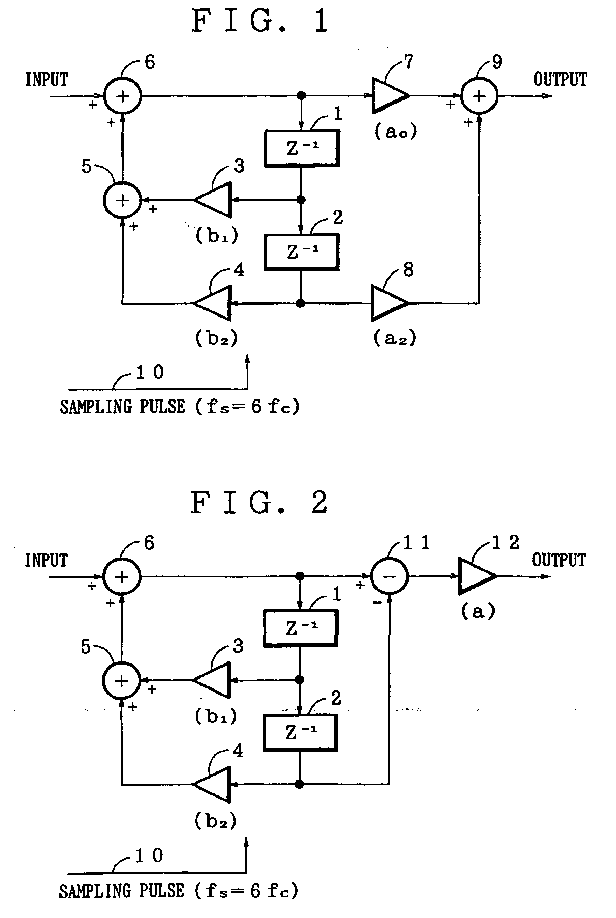

Now referring to Fig. 1, an explanation will be given of a first embodiment of this invention. Fig. 1 is an arrangement view of the first embodiment.

In Fig. 1, reference numerals 1 and 2 denote a delay operator, 3 a first-order input feedback coefficient ($b_1$), 4 a second-order input feedback coefficient ($b_2$), 5 and 6 are an adder, respectively, 7 a zero-order output coefficient ($a_0$), 8 a second-order output coefficient, 9 an adder and 10 a sampling pulse for processing digital signal processing.

The frequency fs of the sampling pulse is set at six times of the central frequency fc of the bandpass filter as expressed by Equation (30). Assuming that n is an odd number of 3 or more, the first-order input feedback coefficient ($b_1$) 3 is set at $-(1-2^{-n})$ and the second-order input feedback coefficient ($b_2$) 4 is set at $1 - 2^{-(n-1)}$.

The zero-order output coefficient ($a_0$) 7 is set at $2^{-n}$ and the second-order output coefficient ($a_2$) 8 is set at $-2^{-n}$.

In the operation with the above settings, at the input and output of the filter, the phase and amplitude can be caused to agree to each other.

Since the coefficient is set as power of 2, it can be easily acquired with high accuracy.

Now referring to Fig. 2, an explanation will be given of a second embodiment of this invention. Fig. 2 is an arrangement view of the first embodiment.

In the first embodiment, the zero-order output coefficient ($a_0$) 7 was set at $2^{-n}$ ($a_0 = 2^{-n}$) and the second-order output coefficient ($a_2$) was set at $-2^{-n}$ ($a_2 = -2^{-n}$).

Specifically, $a_0 = -a_2$. The zero-order output was multiplied by $a_0$, and the second-order output was multiplied by $-a_2$. The outputs thus acquired were added to acquire an output signal.

The second embodiment intends to reduce the number of multiplication.

Specifically, as seen from Fig. 2, in a subtracter 11, the second-order output is reduced from the zero-order output, and the output from the subtracter 11 is multiplied by a coefficient ($a = 2^{-n}$) 12.

A reference signal canceling apparatus according to this invention can be constructed using the second-order IIR digital filter hitherto explained. Specifically, in the second-order IIR digital filter, the central frequency is set at 19 KHz of the pilot signal and the sampling frequency is set at six times as large as this frequency. The digital filter with such settings is substituted for the bandpass filter in the pilot signal canceling apparatus described with reference to Fig. 4. Thus, the phase and amplitude of the pilot signal at the output can be made equal to those at the input. The difference in these phase and amplitude between the input and output can be taken in the subtracter 21 so that the pilot signal can be completely canceled from the FM detected signal. Any configuration can be adopted as long as the reference signal at a single frequency contained in a prescribed signal can be canceled.

Further, for example, in an RDS broadcasting, a reference signal at 57 KHz is superposed on a detected signal for data demodulation. In this case, by setting the sampling frequency at six times as large as 57 KHz, the reference signal at 57 KHz can be easily canceled.

**Claims**

1. A second-order bandpass IIR type digital filter, wherein

a first-order input feedback coefficient $b_1$ is set at $-1 + 2^{-n}$, and
a second-order input feedback coefficient $b_2$ is set at $1 - 2^{-(n-1)}$
where n is an odd number of 3 or larger,
**characterised in that**
a sampling frequency is six times as large as a central frequency of a passing frequency band, and
a zero-order output coefficient $a_0$ is set at $2^{-n}$ ($a_0 = 2^{-n}$) and a second-order output coefficient $a_2$ is set at $-2^{-n}$ ($a_2 = -2^{-n}$).

2. A second-order bandpass IIR digital filter according to claim 1, wherein the second-order output is subtracted from the zero-order output and a subtraction result is multiplied by $2^{-n}$.

3. A reference signal canceling apparatus comprising:

a filter for extracting a reference signal contained in an FM detected signal; and
a subtracter for subtracting an output from the filter from said FM detected signal, wherein said filter is constructed as a second-order bandpass IIR type digital filter according to claim 1 or 2.

**Patentansprüche**

1. Digitales Bandpass-IIR-Filter zweiter Ordnung, wobei

ein Eingangs-Rückkopplungskoeffizient $b_1$ erster Ordnung auf $-1+2^{-n}$ eingestellt ist und
ein Eingangs-Rückkopplungskoeffizient $b_2$ zweiter Ordnung auf $1-2^{-(n-1)}$ eingestellt ist
und n eine ungerade Zahl gleich oder größer 3 ist,
**dadurch gekennzeichnet, dass**
eine Abtastfrequenz sechsmal so hoch ist wie eine Mittenfrequenz eines Durchlass-Frequenzbandes, und
ein Ausgangskoeffizient nullter Ordnung $a_0$ auf $2^{-n}$ ($a_0 = 2^{-n}$) eingestellt ist und ein Ausgangskoeffizient zweiter Ordnung $a_2$ auf $-2^{-n}$ festgelegt ist ($a_2 = -2^{-n}$).

2. Digitales Bandpass-IIR-Filter zweiter Ordnung nach Anspruch 1, wobei der Ausgang zweiter Ordnung von dem Ausgang nullter Ordnung subtrahiert wird und ein Subtraktionsergebnis mit $2^{-n}$ multipliziert wird.

3. Bezugssignal-Unterdrückungsvorrichtung, die umfasst:

ein Filter zum Extrahieren eines Bezugssignals, das in einem FM-Erfassungssignal enthalten ist, und
Subtrahierglied, das einen Ausgang von dem Filter von dem FM-Erfassungssignal subtrahiert, wobei das Filter als ein digitales Bandpass-IIR-Filter zweiter Ordnung nach Anspruch 1 oder 2 aufgebaut ist.

**Revendications**

1. Filtre numérique passe-bande du second ordre de type à réponse impulsionnelle infinie, dans lequel

un coefficient de rétroaction d'entrée de premier ordre $b_1$ est fixé à $-1 + 2^{-n}$, et
un coefficient de rétroaction d'entrée de second ordre $b_2$ est fixé à $1 - 2^{-(n-1)}$
où n est un nombre impair de 3 ou plus,
**caractérisé en ce que**
une fréquence d'échantillonnage est six fois plus grande qu'une fréquence centrale d'une bande de fréquence passante, et
un coefficient de sortie d'ordre zéro $a_0$ est fixé $2^{-n}$ ($a_0 = 2^{-n}$) et un coefficient de sortie de second ordre $a_2$ est fixé $-2^{-n}$ ($a_2 = -2^{-n}$).

2. Filtre numérique passe-bande du second ordre à réponse impulsionnelle infinie selon la revendication 1, dans lequel la sortie de second ordre est soustraite de la sortie d'ordre zéro et un résultat de soustraction est multiplié par $2^{-n}$.

3. Dispositif de suppression de signal de référence comprenant :

un filtre pour extraire un signal de référence contenu dans un signal FM détecté ; et
un soustracteur pour soustraire une sortie provenant d'un filtre dudit signal FM détecté, dans lequel ledit filtre est réalisé comme un filtre numérique passe-bande du second ordre de type à réponse impulsionnelle infinie selon la revendication 1 ou 2.

# FIG. 1

INPUT

OUTPUT

6

7

9

$(a_0)$

1

$Z^{-1}$

5

3

$(b_1)$

2

$Z^{-1}$

4

8

$(b_2)$

$(a_2)$

10

SAMPLING PULSE $(f_s = 6\ f_c)$

# FIG. 2

INPUT

OUTPUT

6

11

12

$(a)$

1

$Z^{-1}$

5

3

$(b_1)$

2

$Z^{-1}$

4

$(b_2)$

10

SAMPLING PULSE $(f_s = 6\ f_c)$

# F I G. 3

# F I G. 4